(19) **Europäisches Patentamt**

**European Patent Office**

**Office européen des brevets**

(11) **EP 0 648 377 B1**

(12) **EUROPEAN PATENT SPECIFICATION**

(45) Date of publication and mention
of the grant of the patent:
**23.08.2000 Bulletin 2000/34**

(51) Int. Cl.[7]: **H01L 31/0352**

(86) International application number:
**PCT/US93/06193**

(21) Application number: **93916853.0**

(22) Date of filing: **29.06.1993**

(87) International publication number:
**WO 94/00884 (06.01.1994 Gazette 1994/02)**

(54) **MINIBAND TRANSPORT QUANTUM WELL DETECTOR**

MINIBAND TRANSPORT QUANTUMWELL INFRAROTDETEKTOR

DETECTEUR A PUITS QUANTIQUES ET A TRANSPORT PAR MINIBANDE

(84) Designated Contracting States:
**DE FR GB IT SE**

(30) Priority: **30.06.1992 US 906417**

(43) Date of publication of application:
**19.04.1995 Bulletin 1995/16**

(73) Proprietor:
**Lockheed Martin Corporation
Bethesda, MD 20817 (US)**

(72) Inventor: **LITTLE, John, W., Jr.
Ellicott City, MD 21043 (US)**

(74) Representative:
**Thomas, Roger Tamlyn et al
D. Young & Co.
21 New Fetter Lane
London EC4A 1DA (GB)**

(56) References cited:
**WO-A-92/08250**

- **APPLIED PHYSICS LETTERS. vol. 59, no. 11, 9 September 1991, NEW YORK US pages 1332 - 1334 YU ET AL. 'A METAL GRATING COUPLED BOUND-TO-MINIBAND TRANSITION GaAs MULTIQUANTUM WELL/SUPERLATTICE INFRARED DETECTOR'**
- **APPLIED PHYSICS LETTERS. vol. 60, no. 8, 24 February 1992, NEW YORK US pages 992 - 994 YU ET AL. 'LOW DARK CURRENT STEP-BOUND-TO-MINIBAND TRANSITION InGaAs/GaAs/AlGaAs MULTIQUANTUM-WELL INFRARED DETECTOR'**
- **PATENT ABSTRACTS OF JAPAN vol. 15, no. 179 (E-1064)8 May 1991**
- **APPLIED PHYSICS LETTERS. vol. 57, no. 5, 30 July 1990, NEW YORK US pages 503 - 505 BYUNGSUNG ET AL. 'LONG WAVELENGTH INFRARED DETECTION IN A KASTALSKY-TYPE SUPERLATTICE STRUCTURE'**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

The present invention is directed to a semiconductor electromagnetic detector and a method of detecting electromagnetic radiation, and is directed particularly to a semiconductor infrared detector having doped quantum wells separated by finite-period superlattices.

Detection of electromagnetic radiation in the medium wavelength infrared (MWIR) band (wavelengths from 3-5 micrometers ($\mu$m)) can be accomplished with several materials, e.g., indium antimonide (InSb). On the other hand, there is only one common detector for the long wavelength infrared (LWIR) band (wavelengths from 8-12 $\mu$m): the narrow-band-gap semiconductor mercury cadmium telluride (HgCdTe).

Many problems with respect to the uniformity of optical and electrical properties and mechanical stability are associated with HgCdTe. As a result, routine fabrication of large HgCdTe detector arrays is not possible. In addition, detectors that are sensitive to more than one band of wavelengths at the same time (sometimes called "two-color" detectors) are not readily available.

Recently, semiconductor structures that have dimensions small enough to make quantum mechanical effects important have been described in the literature, e.g., M. Sundaram et al., "New Quantum Structures", Science vol. 254, pp. 1326-1335 (Nov. 29, 1991). Conventional quantum well infrared photodetectors (QWIPs) respond to thermal radiation with an increase in electrical conductivity that results from internal photoemission of charged carriers from energy states confined in quantum wells. Typical materials used for conventional QWIPs are III-V compound semiconductors such as gallium arsenide and aluminum gallium arsenide. A typical QWIP is a stack of layers in which the layers' materials and widths are carefully selected to achieve a desired distribution of energy states for the device's electrons. See, e.g., B. Levine et al., "New 10 $\mu$m Infrared Detector Using Intersubband Absorption in Resonant Tunneling GaAlAs Superlattices", Appl. Phys. Lett. vol. 50, pp. 1092-1094 (Apr. 20, 1987).

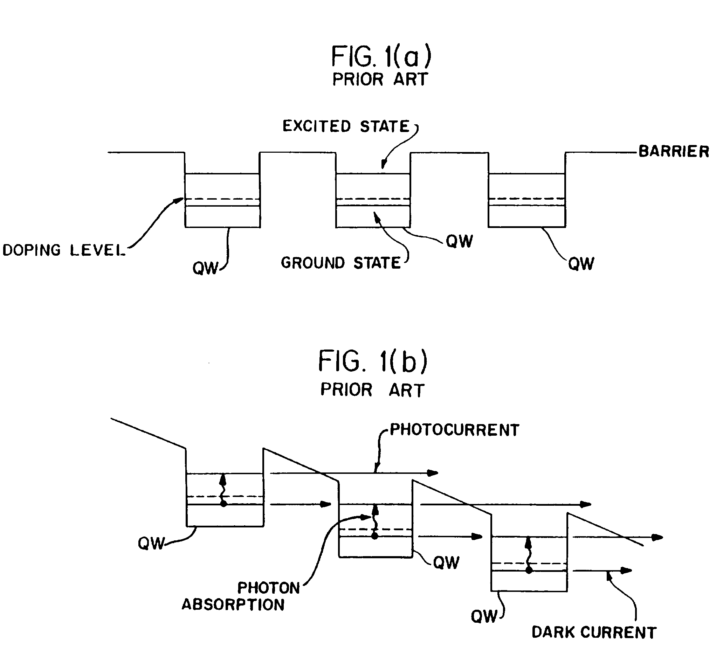

An example of the energy states in a conventional, unbiased QWIP such as that described in the Levine et al. paper is illustrated in Fig. 1(a). General aspects of superlattices, which typically are structures of thin alternating layers of two materials having different electronic properties, are described in G. Dohler, "Solid-State Superlattices", Scientific American vol. 249, pp. 144-151 (Nov. 1983). It will be understood that superlattices, as well as the other structures described in this application, can be fabricated by a wide variety of methods, e.g., vapor deposition methods such as molecular-beam epitaxy and electrochemical deposition methods. See, e.g., J. Switzer et al., "Electrodeposited Ceramic Superlattices", Science vol. 247, pp. 444-445 (Jan. 26, 1990).

Three of the QWIP's quantum wells QW are seen in Fig. 1(a), and the wells have widths and energy depths that are chosen to provide two confined states, the ground state and the excited state. The energy separation between the ground state and the excited state is set equal to the energy of the photon to be detected by the QWIP, and generally increases as the width of the layers corresponding to the quantum wells QW decreases. The well layers are doped with electron donor impurities, e.g., silicon, thereby partially filling the lowest energy state with electrons (as indicated in the figure by the dashed lines). Barriers having thicknesses of typically one hundred Angstroms (100 Å = 10 nm) the quantum wells QW. In a QWIP consisting of a stack of GaAs wells and $Al_xGa_{1-x}As$ barriers, the depth of the wells can be varied over a range of about 500 milli-electron-volts (meV). As noted in the above-cited Sundaram et al. paper, the well depth is proportional to the difference between the bandgaps of the barrier and well layers, and varies almost linearly for $0.0 < x < 0.45$.

When a bias is applied to the QWIP as illustrated in Fig. 1(b), the shape of the distribution of energy states changes. Electrons can jump into the excited states upon absorption of photons having the proper energy, and can tunnel through the barriers separating the wells; these electrons are collected as a current. Conventional QWIPs operate at biases corresponding to internal electric fields of 10-30 kV/cm, which are required for efficient extraction of the photogenerated carriers before recombination. Due to the electrons' tunneling from the ground state through the thin barriers, however, the current that flows in the absence of photons (the "dark current") is unacceptably large in the conventional QWIP.

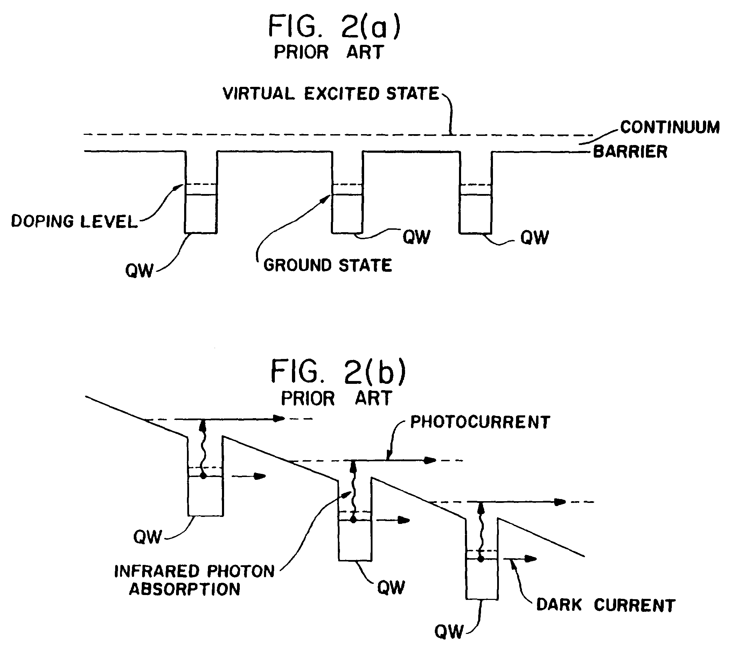

Another type of QWIP is described in B. Levine et al., "High-Detectivity $D^\circ = 1.0 \times 10^{10}$ cm $\sqrt{Hz}$/W GaAs/AlGaAs Multiquantum Well $\lambda = 8.3$ $\mu$m Infrared Detector ", Appl. Phys. Lett. vol. 53, pp. 296-298 (July 25, 1988). An example of the energy states in such an unbiased QWIP is illustrated in Fig. 2(a). In this QWIP, the widths of the quantum wells QW are chosen so that only the ground state is bound in each well and the excited state is slightly above the barrier in the continuum. In such a QWIP, the barriers between the quantum wells are fairly thick, e.g., approximately 500 Å, thereby yielding lower dark current when a bias is applied as illustrated in Fig. 2(b). The carriers can still be collected because photon absorption raises the electrons into the continuum where they can be swept to the QWIP's contacts by the applied electric field before recombination occurs.

Although the QWIP illustrated in Figs. 2(a)-2(b) has lower dark current than the QWIP illustrated in Figs. 1(a)-1(b), it has only one bound state in each quantum well. Also, the energies of the first (virtual) excited states must be close to the tops of the barriers because the photon absorption strength (i.e., the probability of photoexcited transitions between states) decreases rapidly as the excited states move further above the barrier. For a given operating wavelength, these requirements can be satisfied by only one combination of well width and barrier height, eliminating any possibility of selecting detector performance by choosing different well widths and barrier compositions.

In addition, the carriers' effective mass must be low if only one bound state is allowed, thereby limiting such a QWIP to n-type dopants; this is disadvantageous because p-type dopants can lead to devices having lower dark currents. Furthermore, the conventional QWIP's spectral bandwidth can be changed over only a very small range due to fundamental properties of optical excitation of confined carriers to continuum states. As a result of these properties, changing the spectral bandwidth requires pushing the excited states deeper into the continuum, but as described above this dramatically reduces the photon absorption strength, or quantum efficiency.

A QWIP theoretically analyzed in D. Coon et al., "Narrow Band Infrared Detection in Multiquantum Well Structures", Appl. Phys. Lett. vol. 47, pp. 289-291 (Aug. 1, 1985) has a single quantum well and a barrier consisting of a superlattice. Aspects of the Coon et al. paper are described below, but it is important to note the paper admits that practical multiple-quantum-well detectors are beyond the scope of the model it describes. The superlattice barrier thicknesses and compositions described in the Coon et al. paper (superlattice periods, i.e., the distances between same-material layers, ranging from 114-94 Å) provide a very narrow miniband of states (widths ranging from 6-18 meV, respectively). In addition, the paper describes thicknesses and compositions that position the first excited state of the quantum well in the lowest energy miniband of the superlattice in order to obtain a narrow bandwidth infrared detector that would have low dark current.

The Coon et al. paper suggests that electron transport normal to the plane of the quantum well should occur fairly easily. Nevertheless as described above, a bias is necessary to transport the photoexcited carriers for collection before recombination occurs. Applying even the lowest typical bias to a detector such as that described in the Coon et al. paper would render extraction of the photogenerated carriers extremely difficult and inefficient.

As described in E. Mendez et al., "Stark Localization in GaAs-GaAlAs Superlattices under an Electric Field", Phys. Rev. Lett. vol. 60, pp. 2426-2429 (June 6, 1988) and R. Leavitt et al., "Stark Ladders in Strongly Coupled Superlattices and Their Interactions with Embedded Quantum Wells", Phys. Rev. B vol. 41, pp. 5174-5177 (Mar. 15, 1990), for example, miniband states become strongly localized when the potential drop across one superlattice period is comparable to the width of the miniband. The condition for localization of the miniband states to a single superlattice well is the potential drop across one period should be equal to one-half of the miniband width. Even the lowest bias typically necessary to transport carriers out of a QWIP before recombination would completely localize the miniband states of the superlattices in the detector described in the Coon et al. paper.

As a result of such localization, transport of phozoexcited carriers in the detector described in the Coon et al. paper could occur only by tunneling between the localized miniband and quantum well states. It will be appreciated that a tunneling transport process cannot be characterized as easy. Moreover, although the paper suggests that remarkably high quantum efficiencies might be achieved, in fact a detector such as that described in the paper would have a very low quantum efficiency because the probability of the carriers' transport through the detector by tunneling is significantly less than the probability of their recombination.

In addition, the Coon et al. paper describes a theoretical treatment that is valid only for miniband widths that are much smaller than the depths of the superlattice potential wells. Thus, much of the latter portion of the paper and even its title are directed to considerations arising out of the narrowband limitation. Such a narrow miniband would result in a detector having an advantageously low dark current, but would introduce other problems. The minibands described in the paper are so narrow that, as the paper acknowledges, it would be a challenge even to position the quantum wells' excited states in resonance with the minibands.

The paper's approximate solutions of Schroedinger's equation are suitable for detectors having minibands that are narrow to reduce dark current, but do not permit accurate performance prediction, i.e., selection of predetermined properties, of biased MBT detectors having wide minibands. In fact, the paper inaccurately suggests that QWIP's absorption spectrum would have the same width as the miniband and that the absorption strength would be almost constant throughout this width. Thus, it is not surprising that the paper is silent on selectively positioning the excited states within the minibands and the consequent advantageous effects on the absorption spectrum.

Reference is also made to WO-A-92/08250 which describes a miniband transport quantum well infrared detector including a plurality of doped quantum wells having at least two bound states which are surrounded by a plurality of superlattice barrier layers having a miniband with an average energy that is approximately equal to one of the bound states of the quantum wells. Carriers photo-excited from the ground state to the excited states of the doped quantum wells are swept into the miniband by an externally applied electric field for collection as photo current. As a result, a wide range of quantum well widths and barrier heights along with a variety of materials and carrier types may be used so that an easier process of fabricating the semiconductor device can result while providing improved device characteristics such as lowering the dark current.

The present invention provides a broad-band semiconductor miniband-transport quantum well detector, comprising:

a substrate;

means, disposed on the substrate, for absorbing incident photons, the absorbing means comprising a multilayer structure including

a first plurality of first quantum well layers, each first layer having a bound ground energy state and a bound excited energy state.

a second plurality of second quantum well layers, each second layer having a bound ground energy state and a bound excited energy state,

a third plurality of third quantum well layers, each third layer having a bound ground energy state and a bound excited energy state, and

a plurality of superlattice barrier layers interleaved between the first, second, and third quantum well layers, each superlattice barrier layer having a miniband of energy states in resonance with the excited energy states of its adjacent quantum well layers; and

first and second contact layers disposed on top and bottom surfaces, respectively, of the multilayer structure; wherein the minibands and excited energy states provide an electrically continuous channel across the layers for carriers excited from the ground energy states to the excited energy states and minibands by absorption of photons when different electric potentials are applied to the contact layers, the excited energy states of the first quantum well layers are positioned near the bottom of the minibands, the excited energy states of the second quantum well layers are positioned near the middle of the minibands, and the excited energy states of the third quantum well layers are positioned near the top of the minibands.

The invention can also provide a miniband transport QWIP having a spectral response that is nearly constant over a broad range of wavelengths such as the atmospheric transmission windows of 3-5 $\mu$m and 8-12 $\mu$m.

The invention can also provide a miniband transport QWIP that is sensitive to radiation in one or more wavelength band.

The invention can also provide a miniband transport quantum well detector having predetermined electro-optical properties, e.g., dark-current dependence on applied bias voltage and response and detectivity dependence on incident wavelength. Such properties are determined by the density, location and type of the detector's dopants and by the thickness and composition of the detector's layers.

The invention can also provide a miniband transport quantum well detector in which the wells' excited states are selectively positioned within the miniband to improve the detector's spectral response characteristics.

The thickness and compositions of the quantum well layers and of the thin first and second layers of the miniband transport quantum well detector are such that each quantum well has a ground state and an excited state and the energy of the excited state is substantially equal to energies of selected states within the minibands of the adjacent superlattice barrier layers. In this way, an electrically continuous channel through the multilayer structure is provided, and the detector's optical characteristics, such as the peak-response wavelength and the spectral bandwidth, are determined by an interaction of the energy states of the quantum well layers and the minibands of the superlattice barrier layers.

Preferably, the energies of the quantum well layers' excited states may be substantially equal to the energies of a predetermined pattern of states in the minibands, thereby obtaining an MBT detector having predetermined optical characteristics.

A plurality of quantum wells that each have two bound energy states may be used so that a wide range of materials and carrier types may be used to obtain a predetermined peak-response wavelength. For example, the MBT detector may include 78-Å-wide GaAs quantum well layers and GaAs/Al$_{0.3}$Ga$_{0.7}$As superlattice barrier layers to obtain a peak response wavelength of about 10 $\mu$m. Alternatively, the MBT detector could include 87-Å-wide GaAs quantum well layers and GaAs/Al$_{0.4}$Ga$_{0.6}$As superlattice barrier layers to obtain substantially the same peak-response wavelength. As a further alternative, the MBT detector could include 46-Å-wide In$_{0.15}$Ga$_{0.85}$As quantum well layers and Al$_{0.3}$Ga$_{0.7}$As/Al$_{0.4}$Ga$_{0.6}$As superlattice barrier layers to obtain a peak-response wavelength of about 5 $\mu$m.

## BRIEF DESCRIPTION OF THE DRAWINGS

The invention and its objects and advantages win be understood from the following detailed description and the accompanying drawings, in which:

Figs. 1(a) and 1(b) illustrate the energy states of a conventional QWIP without bias and with bias, respectively; Figs. 2(a) and 2(b) illustrate the energy states of another conventional QWIP without bias and with bias, respectively;

Fig. 3 illustrates part of the semiconductor structure of a miniband transport quantum well detector in accordance with the present invention;

Fig. 4 illustrates a cross-section of a miniband transport QWIP having the semiconductor structure shown in Fig. 3;

Figs. 5(a) and 5(b) illustrate the energy states of a miniband transport quantum well detector without bias and with bias, respectively;

Fig. 6 shows a measured photocurrent response spectrum of a miniband transport QWIP in which the energies of the excited states of the quantum wells are near the bottom of the miniband;

Fig. 7 shows the measured bias dependence of the detectivity of the miniband transport QWIP of Fig. 6;

Fig. 8(a) illustrates calculated squared wavefunctions for a miniband transport quantum well detector in which the energy of a quantum well's excited state is near the bottom of the miniband;

Fig. 8(b) illustrates a calculated absorption spectrum for a miniband transport QWIP in which the energies of the excited states are near the bottom of the miniband;

Fig. 9(a) illustrates calculated squared wavefunctions for a miniband transport quantum well detector in which the energy of a quantum well's excited state is near the center of the miniband;

Fig. 9(b) illustrates a calculated absorption spectrum for a miniband transport QWIP in which the energies of the excited states are near the center of the miniband;

Fig. 10(a) illustrates calculated squared wavefunctions for a miniband transport quantum well detector in which the energy of a quantum well's excited state is near the top of the miniband;

Fig. 10(b) illustrates a calculated absorption spectrum for a miniband transport QWIP in which the energies of the excited states are near the top of the miniband;

Figs. 11(a) and 11(b) illustrate measured photocurrent response spectra of miniband transport QWIPs;

Fig. 12(a) illustrates the energy states of a broad-band miniband transport quantum well detector in accordance with the present invention in which the energies of the excited states are positioned in a pattern within the miniband;

Fig. 12(b) illustrates an absorption spectrum of the broad-band miniband transport quantum well detector of Fig. 12(a);

Fig. 13 illustrates calculated relative absorption spectra for miniband transport QWIPs in accordance with the present invention;

Figs. 14(a) and 14(b) illustrate measured absorption spectra for miniband transport QWIPs in which the energies of the excited states are positioned near the bottom of the miniband and in a pattern within the miniband, respectively;

Fig. 15(a) illustrates the energy states of a two-color miniband transport quantum well detector;

Fig. 15(b) shows a measured photocurrent response spectrum for a two-color miniband transport QWIP; and

Fig. 16 illustrates the energy states of a p-type miniband transport quantum well detector.

## DETAILED DESCRIPTION

As described in more detail below, Applicant's semiconductor electromagnetic detector comprises a plurality of doped quantum well layers separated by finite-period superlattice barrier layers. In accordance with Applicant's invention, the superlattice barrier layers have minibands of energy states that are electrically and optically coupled to states of the quantum wells. Thus, the superlattice barrier layers contribute substantially to the optical characteristics (e.g., the peak-response wavelength and the spectral bandwidth) of the detector. Both the peak-response wavelength and the spectral bandwidth of the detector are determined by the thicknesses and compositions of the layers. The thicknesses and compositions can be chosen from a wide range of possible values to obtain predetermined peak-response wavelengths.

In accordance with Applicant's invention, the finite-period superlattice layers form actual barriers to carriers in the ground states of the quantum well layers. Using superlattices as barriers permits more adjustability and control of detector characteristics than is possible with previous structures such as those described in the above-cited papers by Levine et al. The number of periods in the finite-period superlattices is chosen sufficiently large that dark current due to tunneling out of the wells' ground states is substantially eliminated.

Also, the thicknesses and compositions of the thin layers of the superlattice barrier layers are selected such that the layers have minibands that strongly interact, or merge, with the quantum well layers' excited states. Moreover, the widths of the minibands of the superlattice barrier layers are much larger than the drop in potential across a period of the superlattice when the detector is biased. As described in the above-cited Mendez et al. and Leavitt et al. papers, this ensures that the minibands do not break up into series of strongly localized states and the minibands remain strongly coupled to each other. Thus, an electrically continuous channel trough the detector is provided despite the interruption of the superlattices by the quantum well layers, which would otherwise impede the transport of photoexcited carriers. A carrier photoexcited into a well's excited state (or a miniband state) can be transported easily under the influence of the applied bias through the detector and be collected at suitable contacts as photocurrent.

It will be appreciated a detector in accordance with Applicant's invention is thus significantly different from previous detectors such as that described in the above-cited Coon et al. paper. Detectors in accordance with Applicant's invention have miniband widths typically ranging from 50-120 meV and superlattice periods of 60-40 Å, respectively, and thus localization effects are significant only for very high internal electric fields (40-150 kV/cm, respectively). In contrast, the Coon et al. paper discloses superlattice layer thicknesses and compositions that yield a very narrow (6-18 meV) miniband in order to obtain a narrow bandwidth infrared detector. Such superlattices would collapse into completely localized states for the 10-30 kV/cm internal electric fields that are needed for extraction of photogenerated carriers. It will therefore be appreciated that the extraction of photoexcited carriers from the Coon et al. detector would be extremely inefficient.

In addition, the Coon et al. paper does not suggest that the detector's response is partially determined by the relation between the wells' excited states' energies and the energies of states in the minibands. As described above, the paper's theoretical treatment is valid only for miniband widths that are much smaller than the depths of the superlattice potential wells, and leads to an absorption spectrum that has the same width as the miniband and is substantially constant throughout that width. It will be appreciated that the approximations used in the paper should not be extrapolated to wide minibands. As described in more detail below, exact solutions (i.e., solutions valid for all miniband widths) to the Schroedinger equation for detectors in accordance with Applicant's invention show the excited state's position relative to the miniband has a profound effect on the absorption spectrum.

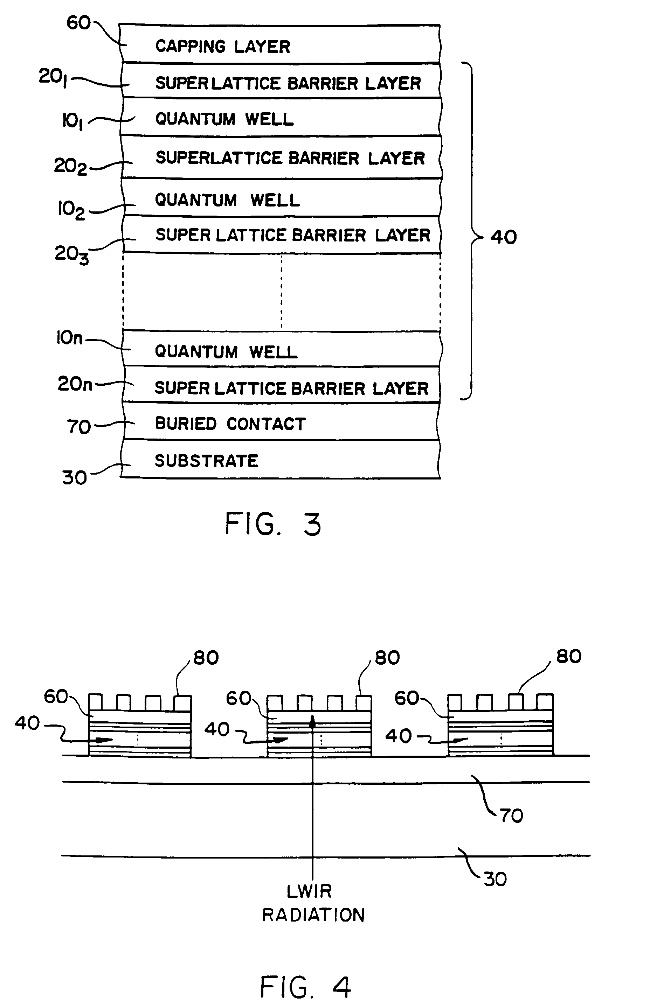

Fig. 3 illustrates part of the semiconductor structure of a miniband transport (MBT) quantum well detector. The MBT detector comprises a plurality of quantum well layers $10_1$-$10_n$ interleaved between a plurality of superlattice barrier layers $20_1$-$20_n$. The interleaved layers are disposed on a substrate 30 and are a multilayer structure denoted by the reference numeral 40. A capping layer 60 and a buried contact 70 are provided on each end of the multilayer structure 40.

Fig. 4 is a cross-section of a plurality of MBT detectors that are arranged as pixels in an array for detecting LWIR radiation that is incident through the substrate. (Only three MBT detectors are shown in the figure, but it will be appreciated that the array may comprise a larger number of pixels.) Each pixel is delineated and its buried contact 70 exposed by suitably etching away the material surrounding the pixels.

As illustrated in Fig. 4, each pixel advantageously includes an optical diffraction grating 80 that may be etched into the capping layer 60 and that may have a metal contact deposited on its upper surface. It will be appreciated that light incident through the substrate 30 is not detected as it passes through the multilayer structure 40. The gratings, which have dimensions and efficiencies appropriate for the wavelengths to be detected, produce a diffracted component of the incident light that is polarized perpendicular to the detectors' layers and that is detected. It will be understood that such a polarization is required by the selection rules governing the absorption of infrared light in quantum wells, as described in, e.g., L. West et al., "First Observation of an Extremely Large-Dipole Infrared Transition within the Conduction Band of a GaAs Quantum Well", Appl. Phys. Lett. vol. 46, pp. 1156-1158 (June 15, 1985), which is incorporated here by reference. Thus, the gratings facilitate fabrication of two-dimensional arrays of MBT detectors. The upper-surface metallization is advantageous because it permits mass electrical connection to the detectors in an array by a technique such as indium-bump bonding.

Instead of or in addition to the gratings 80, any of the various known techniques for increasing the proportion of the incident light that may be detected may be used with Applicant's MBT detectors. For example, the grazing lines may be etched into the surface of the substrate 30 if the imaging properties of the array are not important. The photons diffracted through the detectors may then be reflected by metallic capping layers 60, and the reflected photons would have another chance at absorption in the array pixels. Also, two-dimensional gratings might be used, although such gratings would have some effect on efficiency.

Each of the quantum wells formed in layers $10_1$-$10_n$ contains a ground state and an excited state. In addition, each of the superlattice barrier layers $20_1$-$20_n$ is comprised of a plurality of thin, lower-bandgap layers (quantum wells) separated by thin, higher-bandgap layers (barriers). As described above, the superlattice layers' thicknesses and compositions are chosen so that the energy states of the thin quantum wells merge to form a wide (approximately 50-150 meV) miniband of energy states that is in resonance with the excited states of the quantum well layers $10_1$-$10_n$.

As used in the current application, "resonance" between a superlattice barrier's miniband and a quantum well's excited state means that the energy of the well's excited state is either slightly below the miniband's lowest energy (viz., at the "bottom" of the miniband), between the miniband's lowest and the highest energies, or slightly above the miniband's highest energy (viz., at the "top" of the miniband). This relationship is also referred to below as one in which the excited state is positioned within the miniband because the miniband of a finite-period superlattice barrier does not disappear completely outside the barrier but continues into the adjacent quantum wells. If the quantum well's excited state is positioned below the bottom or above the top of the miniband, it is believed that such an excited state's energy should be, as a practical matter, within 5-10 meV of the miniband's top or bottom in order to maintain coupling between the excited state and the miniband. For excited states further away from the miniband, the carriers would have to tunnel into the miniband.

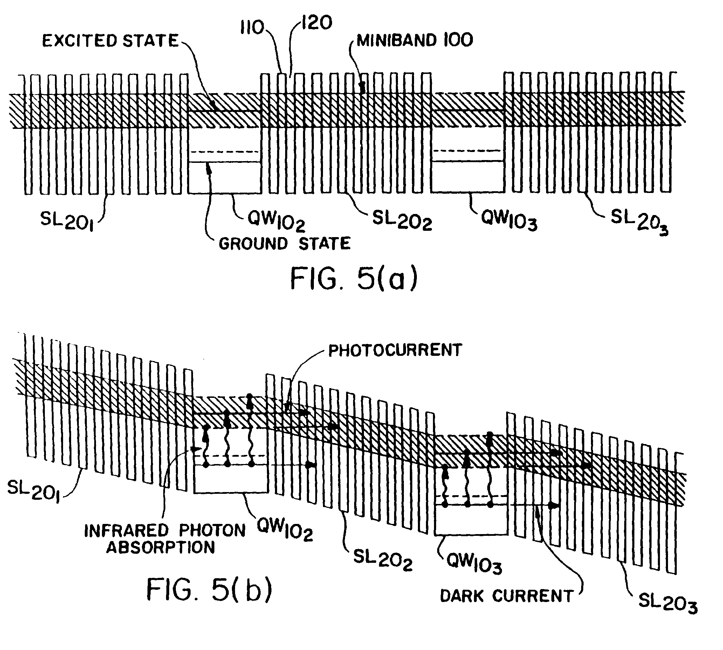

An example of the energy states of an unbiased MBT detector in accordance with Applicant's invention is illustrated in Fig. 5(a), which shows the excited states of the quantum wells QW-$10_2$, QW-$10_3$ falling between the top and bottom of a miniband 100 formed by the superlattice barrier layers $20_1$-$20_3$ comprised of thin barrier layers 110 and thin well layers 120. The quantum well layers $10_2$, $10_3$ are preferably doped so that the wells' ground states are partially filled with carriers (signified by the dotted lines in the wells QW-$10_2$, QW-$10_3$).

Fig. 5(b) illustrates the effect on the energy states of an electric field applied to the structure: the miniband 100 is tilted. The carriers in the ground states of the quantum wells may thus be lifted into the wells' excited states or the miniband states by the absorption of suitably energetic photons (three are shown in the figure). With the wells' excited states in resonance with the superlattice barriers' minibands, the minibands remain strongly coupled to each other and the probability of photoinduced transitions into miniband states is increased. In this way, the carriers can move with relative ease under the influence of the applied bias through the layers $10_1$-$10_n$, $20_1$-$20_n$ for collection at the contact layer 70 as a photocurrent.

The superlattice baffler layers $20_1$-$20_n$ are preferably of such a thickness that the probability of carriers tunneling directly from one quantum well's ground state into the states in the adjacent well, the miniband, or the continuum is substantially zero for the biases typically applied to the structure. In other words, the tunneling component of the dark current is approximately zero for Applicant's MBT detector, which is in sharp contrast to the conventional QWIP behavior illustrated in Fig. 1(b).

Also, the heights of the thin barrier layers of the superlattice barrier layers $20_1$-$20_n$ are preferably such that the probability of thermionic emission of carriers into states above the barriers (i.e., states in the continuum) is substantially zero for the MBT detector's operating temperature. MBT detectors suitable for the MWIR and LWIR bands would typically operate at about 77 K. Under these conditions, the MBT detector's dark current results from thermionic emission of carriers into the miniband, and therefore depends on the difference in energy between the wells' ground states and the bottom of the miniband.

An MBT detector has been made by molecular-beam epitaxy on a GaAs substate. The MBT detector includes forty GaAs quantum well layers, each of which is 78 Å thick and is doped with silicon to a concentration of $4 \times 10^{17}$ cm$^{-3}$. The quantum well layers are separated by superlattice barrier layers in the manner illustrated in Fig. 3; each superlattice barrier layer is comprised of nine thin GaAs wells, each approximately 20 Å thick, and ten thin Al$_{0.3}$Ga$_{0.7}$As barriers, each approximately 40 Å thick. The MBT detector had 1-μm-thick capping and buried contact layers made of heavily doped GaAs formed above and below the active quantum well layers.

Such compositions and thicknesses of the quantum well and superlattice barrier layers yield an MBT detector having a miniband width of about 50 meV, the wells' excited states at the bottom of the miniband, and an energy difference between the wells' ground and excited states of approximately 118 meV. That energy difference corresponds to a peak-response wavelength of about 10.5 μm. Calculations have shown that an MBT detector having 87-Å-thick GaAs quantum well layers and GaAs/Al$_{0.4}$Ga$_{0.6}$As superlattice barrier layers would have substantially the same optical properties. Thus, MBT detectors having similar properties may be made from a variety of compositions and thicknesses

In an arrangement similar to that illustrated in Fig. 4, a plurality of such MBT detectors having various areas were then defined on the substrate by chemical etching. It will be appreciated that the upper limit on detector size (detectors as large as 500 μm have been built) is usually determined by the acceptable dark current, which is proportional to area, and to a lesser extent by defects produced during fabrication. The lower limit on detector size (about 1 μm for MBT detectors, which are typically about 2-4 μm thick) is mainly determined by the etching and lithography processes used. Instead of having gratings disposed at the capping layers 60 as shown in Fig. 4, however, triangular gratings having a 4-μm-pitch were etched into the substrate 30 so that light polarized perpendicular to the quantum well layers was incident on the pixels. Also, ohmic metal contacts were deposited on the capping and (now partially exposed) buried contact layers.

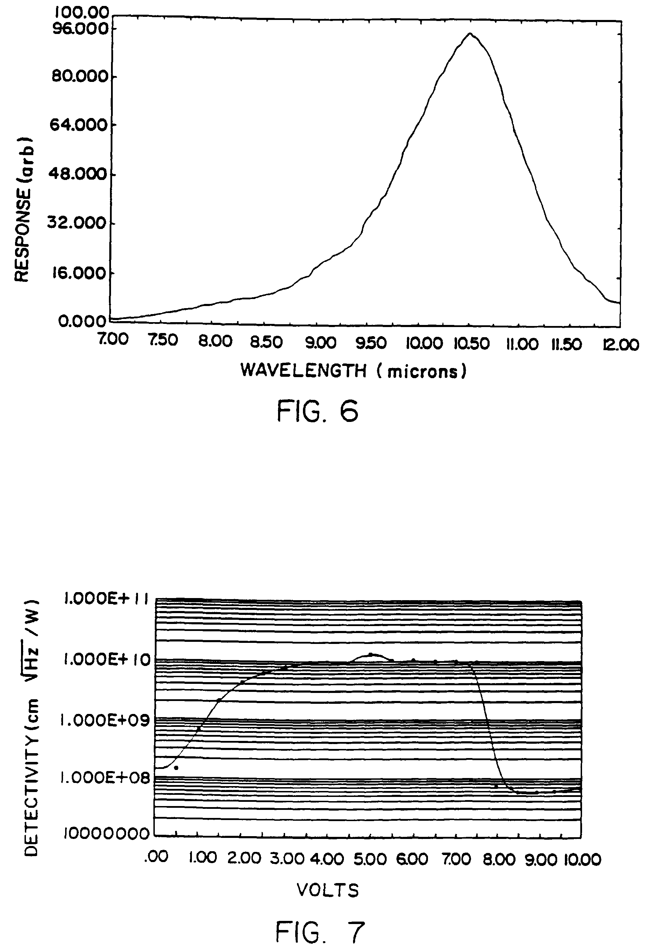

Figs. 6 and 7 illustrate measured characteristics of one of the MBT detectors. Fig. 6, which shows the relationship between incident wavelength and MBT detector response (in arbitrary units of photocurrent), indicates a peak-response wavelength of about 10.5 μm and a long-wavelength cutoff (the half-peak point) of about 11.1 μm. Fig. 7, which shows the relationship between applied bias voltage and detectivity at a detector operating temperature of 77 K, indicates the tested MBT detector has a peak D° = $1 \times 10^{10}$ cm Hz$^{1/2}$W$^{-1}$.

It will be appreciated that MBT detectors and arrays can be made that have other layer compositions and thicknesses. In particular, the energies of the excited states and the miniband states can be chosen to obtain desired optical and electrical characteristics, and the layer compositions and thicknesses can be chosen from a wide range of possible materials and values. In general, MBT detectors in accordance with Applicant's invention can be made from any materials suitable for making quantum wells, e.g., aluminum gallium arsenide, pseudomorphically strained indium gallium arsenide on gallium arsenide substrates, and lattice-matched indium gallium arsenide on indium phosphide substrates. In addition, it will be appreciated that such intersubband detectors on GaAs are currently most useful for wavelengths between about 3 μm and about 19 μm. Moreover, the doping, which leads to the desired light absorption in the quantum well layers, may be varied in concentration, and possibly in position as well (i.e., the detectors may be made with modulation doping of the superlattice barrier layers).

It will be understood that the doping level determines the strength of photon absorption, which is directly proportional to the two-dimensional doping density. On the other hand, as the doping level increases, the fermi level of the ground state gets closer to the bottom of the miniband, increasing thermionic emission into the miniband and thus the dark current. In general, it is believed that doping levels in the range of about $1 \times 10^{17}$ cm$^{-3}$ to $2 \times 10^{18}$ cm$^{-3}$ are suitable for the MBT detectors described in this application. It will be appreciated that for MBT detectors responsive to the MWIR band the doping levels can be higher than they are for LWIR MBT detectors, viz., closer to $10^{18}$ cm$^{-3}$, because the energy separation of the ground state and the excited and miniband states is greater. Also, lower operating temperatures would typically permit higher doping levels without increased dark current as described below.

Exact Airy function solutions of Schroedinger's equation, including an applied field, are preferably used to determine the energies and wavefunctions of carriers in the quantum wells and the superlattice barriers of the MBT detector. See, e.g., C. Weisbuch et al., Quantum Semiconductor Structures, pp. 19-20, Academic Press (1991) and M. Abramowitz et al., eds, Handbook of Mathematical Functions, Applied Mathematics Series 55, pp. 446-455, National Bureau of Standards, Washington, D.C. (June 1964), which are incorporated here by reference. In general, such solutions are sums of Airy functions with boundary conditions imposed by the detector structure that lead to discrete energy solutions and specific carrier wavefunctions. (It will be appreciated that the square of the wavefunction gives the probability of finding the carrier at positions in the detector.) The probability of photon absorption is determined from the square of the dipole matrix element that depends on the overlap integral of the product of the final state wavefunction and the derivative of the ground state wavefunction. The final state can be the excited state of one of the quantum wells $10_1$-$10_n$ or any of the miniband states of the superlattice barriers $20_1$-$20_n$.

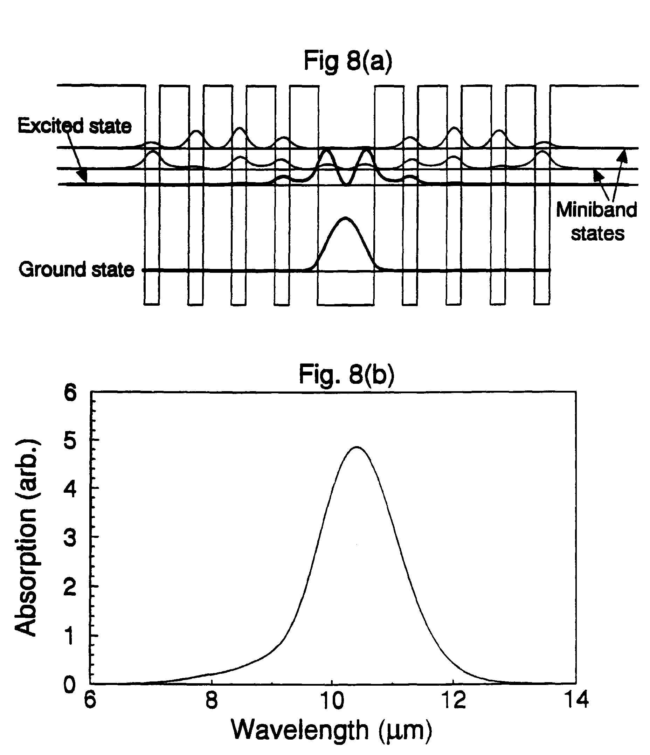

From such exact solutions of Schroedinger's equation, the MBT detector's characteristics can be predicted accurately and precisely tailored. Approximate solutions, such as those described in the above-cited Coon a al. paper, do not permit accurate performance prediction, i.e., selection of predetermined properties, of biased MBT detectors having wide minibands, although such approximations are suitable for detectors having minibands that are narrow to reduce dark current. Based on such exact solutions, Figs. 8(a)-10(b) illustrate the effect of the relationship between the energies of the excited state and the miniband states on the optical characteristics of an MBT detector.

Fig. 8(a) illustrates calculated squared wavefunctions for carriers in a well's ground and excited states and selected miniband states of an MBT detector having layer compositions and thicknesses chosen such that the excited state's energy is near the bottom of the miniband. As shown, the magnitudes of the squared wavefunctions of carriers in the miniband states in the vicinity of the central quantum well are largest for states having energies nearest that of the excited state and decrease for states having higher energies. As described above, this interaction of the well's excited state with the miniband states significantly contributes to the electro-optical properties of Applicant's MBT detector.

Fig. 8(b) illustrates the calculated absorption spectrum for the MBT detector yielding the wavefunctions shown in Fig. 8(a). The absorption spectrum can be determined in a straightforward way from the calculated probabilities of photon absorption, and is proportional, but not usually identical, to the photocurrent response spectrum. The absorption spectrum is mainly determined by the photoinduced transition from the ground state to the excited state near the bottom of the miniband. Nevertheless, it will be noted that the absorption spectrum also has a short-wavelength (high-energy) tail that is due to photoinduced transitions from the ground state into higher-energy miniband states. The fact that the calculated absorption spectrum shown in Fig. 8(b) is similar to the measured absorption spectrum shown in Fig. 6 confirms that the fabricated and measured MBT detector had the excited state's energy near the bottom of the miniband.

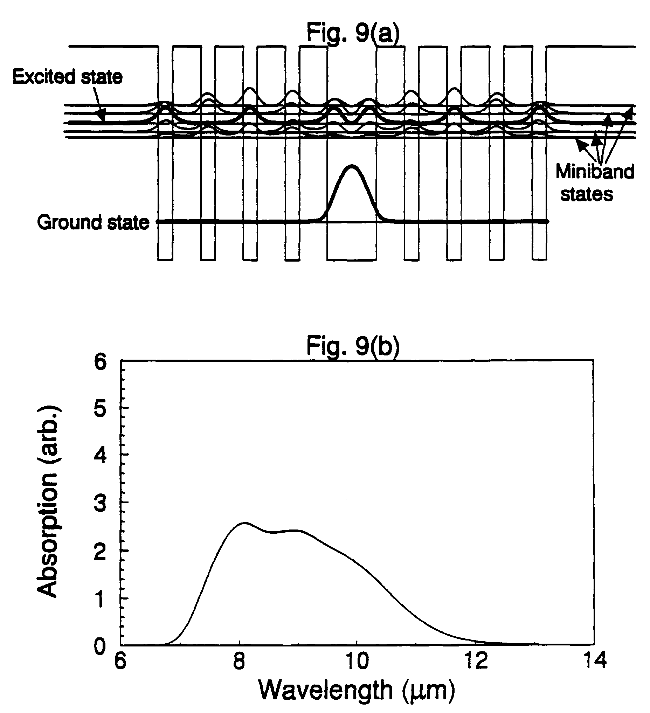

Fig. 9(a) illustrates calculated squared wavefunctions for carriers in a well's ground and excited states and selected miniband states of an MBT detector having layer compositions and thicknesses chosen such that the excited state's energy is near the center of the miniband. As shown, the magnitudes of the squared wavefunctions of carriers in the miniband states in the vicinity of the quantum well are largest for states having energies nearest that of the excited state and decrease for states having higher or lower energies. It will be noted that the squared wavefunction magnitudes of carriers in states at the top and bottom of the miniband are still substantial in the vicinity of the quantum well.

Fig. 9(b) illustrates the calculated absorption spectrum for the MBT detector yielding the wavefunctions shown in Fig. 9(a). The absorption spectrum is broad because the probabilities of photoinduced transitions from the well's ground state into the excited state and the miniband states are all substantial as indicated in Fig. 9(a).

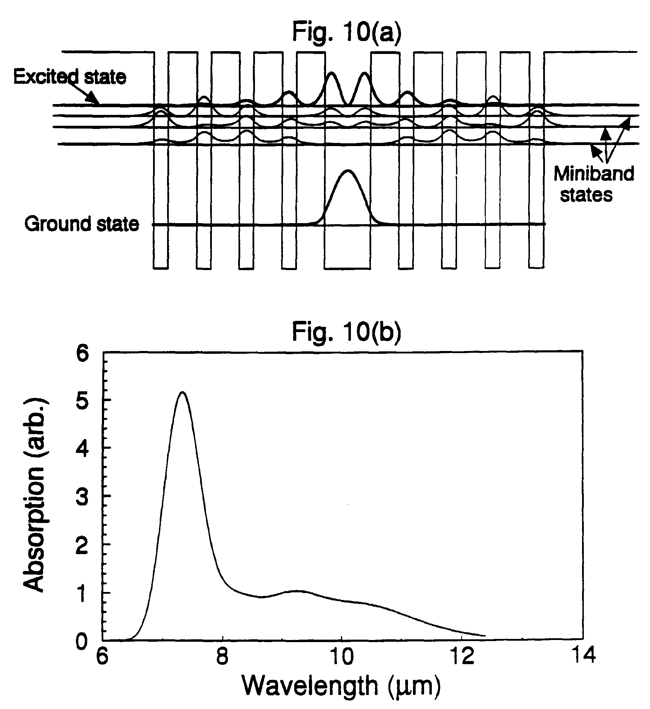

Fig. 10(a) illustrates calculated squared wavefunctions for carriers in a well's ground and excited states and selected miniband states of an MBT detector having layer compositions and thicknesses chosen such that the excited state's energy is near the top of the miniband. As shown, the magnitudes of the squared wavefunctions of carriers in the miniband states in the vicinity of the quantum well are largest for states having energies nearest that of the excited state and decrease for states having lower energies.

Fig. 10(b) illustrates the calculated absorption spectrum for the MBT detector yielding the wavefunctions shown in Fig. 10(a). The absorption spectrum is mainly determined by the photoinduced transition from the ground state to the excited state near the top of the miniband. It will be noted that the absorption spectrum also has a long-wavelength (low-energy) tail that is due to photoinduced transitions from the ground state into lower-energy miniband states.

Similar calculations have been performed for structures in which the energies of the excited states are substantially different from any of the miniband state energies (viz., structures in which the excited states are not in resonance with, or positioned within, the miniband). The calculations show that the magnitudes of the squared wavefunctions of carriers in the miniband states are substantially zero in the vicinity of the quantum well. Thus, the minibands of the superlattice barrier layers would not be strongly coupled to one another other, and reflection of carriers at each superlattice-barrier-layer/quantum-well-layer interface would be substantial, thereby greatly impeding carrier transport through the structure.

Using exact solutions of Schroedinger's equation, Figs. 8(a)-10(b) illustrate that an MBT detector's absorption spectrum and the miniband carrier wavefunctions can be substantially modified by selectively positioning the energy of the excited state within the miniband. The calculations illustrated in these figures have been verified by measurements performed on fabricated MBT detectors.

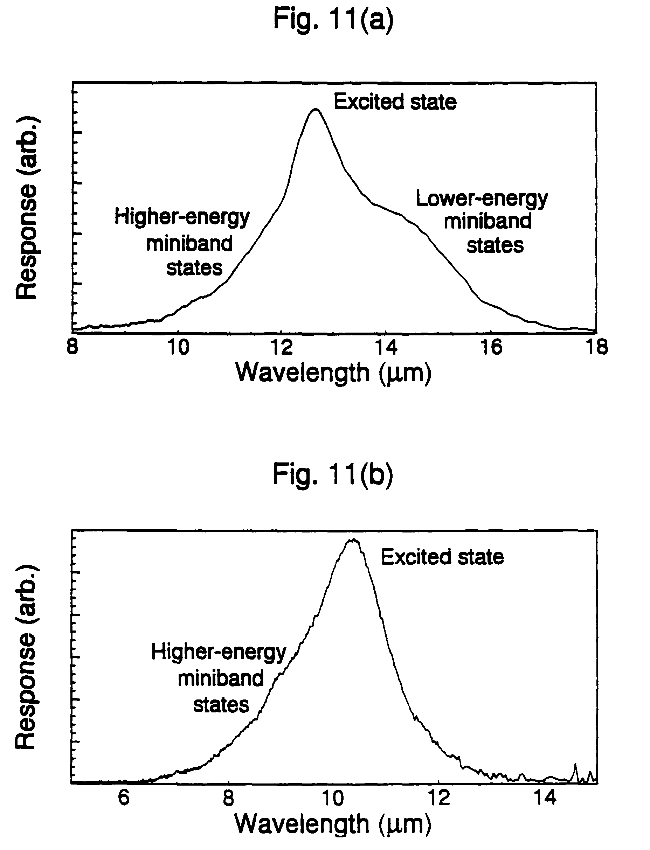

Fig. 11(a) shows a measured photocurrent response spectrum (in arbitrary units of photocurrent) of an MBT detector in which the energies of the excited states are near the center of the miniband. The measured peak-response wavelength, which is due mainly to the photoinduced transitions to the excited states, was close to 13 μm. As described above in connection with Fig. 9(b), the short-wavelength tail is due to transitions to the higher-energy miniband states, and the long-wavelength tail is due to transitions to the lower-energy miniband states. The MBT detector had forty 100-Å-thick GaAs quantum well layers doped with silicon to a concentration of $4 \times 10^{17}$ cm$^{-3}$ and superlattice barrier layers each having fourteen 24-Å-thick GaAs wells and fifteen 20-Å-thick $Al_{0.3}Ga_{0.7}As$ barriers.

Fig. 11(b) shows a measured photocurrent response spectrum (in arbitrary units of photocurrent) of an MBT detector having 78-Å-thick quantum well layers and the energies of the excited states positioned near the bottom of the miniband like the detector illustrated in Fig. 6. The measured peak-response wavelength, which is due mainly to the photoinduced transitions to the excited states, was close to 10μm. As described above in connection with Figs 6 and 8(b), the short-wavelength tail is due to transitions to the higher-energy miniband states, and such a photocurrent response spectrum could be produced by a variety of layer compositions and thicknesses.

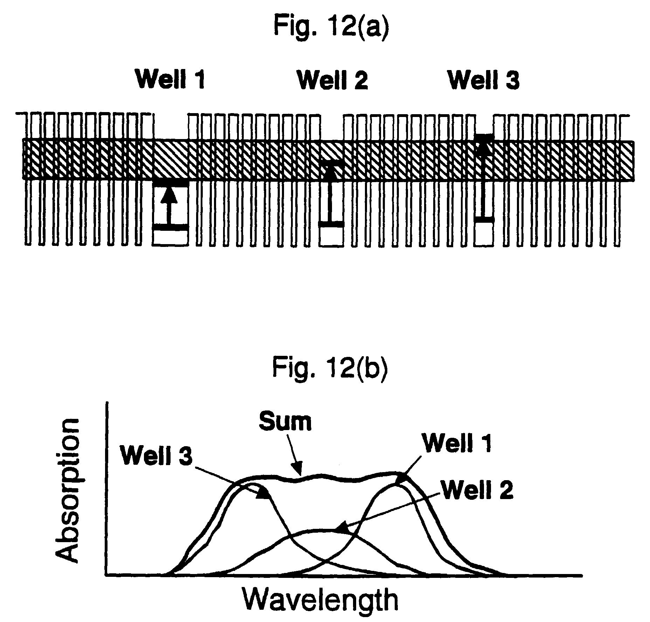

In accordance with the invention, the widths of the quantum well layers can be chosen such that energies of excited states are positioned within the miniband in a pattern, with states near the bottom, center, and top of the miniband. Fig. 12(a) illustrates the energy stares of such an MBT detector in which all of the superlattice barrier layers are the same and the widths of the quantum wells are varied. As shown in the figure, the excited states' energies of three quantum wells are positioned near the bottom (well 1), center (well 2), and top (well 3) of the miniband. It will be appreciated that such a three-well pattern would usually be repeated many times to form the MBT detector.

Fig. 12(b) illustrates the calculated absorption spectrum of an MBT detector having the energies of the excited states positioned in such a pattern within the miniband. The total spectrum of the detector is a sum of the absorption spectra of the wells 1-3 (shown as half-tone lines in the figure), and advantageously spans a broad band of wavelengths with nearly constant response over the band. In contrast, it will be appreciated that, in a conventional QWIP having a virtual excited state above the barrier, the absorption strength falls off monotonically as the width of the well is decreased (i.e., as the transition energy is increased). Thus, the strong, short-wavelength absorption required for the broad-band response shown in Fig. 12(b) can only be obtained in a conventional QWIP by varying the composition of each of the barrier layers, thereby making detector fabrication significantly more difficult.

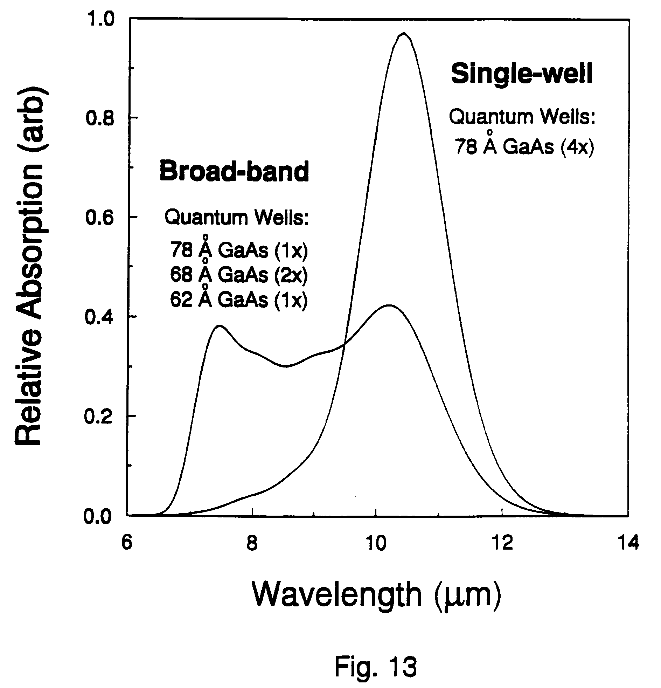

Fig. 13 presents a comparison of two MBT detectors that both have the same total number of quantum well layers, but the layers of one detector all have the same width and the layers of the other have widths such that their excited states are positioned in a pattern in the minibands. Fig. 13 illustrates a calculated absorption spectrum of an MBT detector having four (or an integer multiple of four) GaAs quantum well layers, all of which have the same 78 Å width. Such a single width positions the wells' excited states near the bottom of the miniband formed by the above-described superlattice barrier layers. Also shown in Fig. 13 is a calculated absorption spectrum of a broad-band MBT detector in accordance with the invention having four (or an integer multiple of four) GaAs quantum well layers of differing widths. In this example, one (or one-fourth of the total) of the quantum wells is 78 Å wide, positioning the excited state near the bottom of the miniband. Another two (or two-fourths of the total) of the wells are each 68 Å wide, positioning the excited state near the center of the miniband. The remaining well (or one-fourth of the total) is 62 Å wide, positioning the excited state near the top of the miniband.

As seen from Fig. 13, the two spectra represent the same integrated absorption strength, but the response of the broad-band detector of the invention is nearly constant over a wavelength band that is much larger than that of the single-well-width detector. Such a broad-band, uniform-response detector would be desirable as elements of imaging arrays because such arrays would have less variation in response due to variations in layer thickness and material composition over the area of the array.

It will be appreciated that the solutions to Schroedinger's equation do not depend on the layers' total number, which is limited mainly by the fabrication processes used and the relation between the times for carrier recombination and transport out of the detector. In addition, the order of the widths generally does not affect performance, although disposing the low-energy layers "downhill" in the applied bias field might affect the dark current.

On the other hand, the broad-band detector's response is determined by the relative numbers of thick, thicker, and thickest layers. As shown in Fig. 13, twice as many 68-Å-wide layers, which contribute a broader component of the detector's response due to the positioning of the excited states in the middle of the miniband, are provided to compensate for those layers' relatively lower response and to obtain a uniform-response detector. Thus, in accordance with the invention, the numbers of layers, as well as the layers' compositions and thicknesses, can be selected to obtain an MBT detector having predetermined properties.

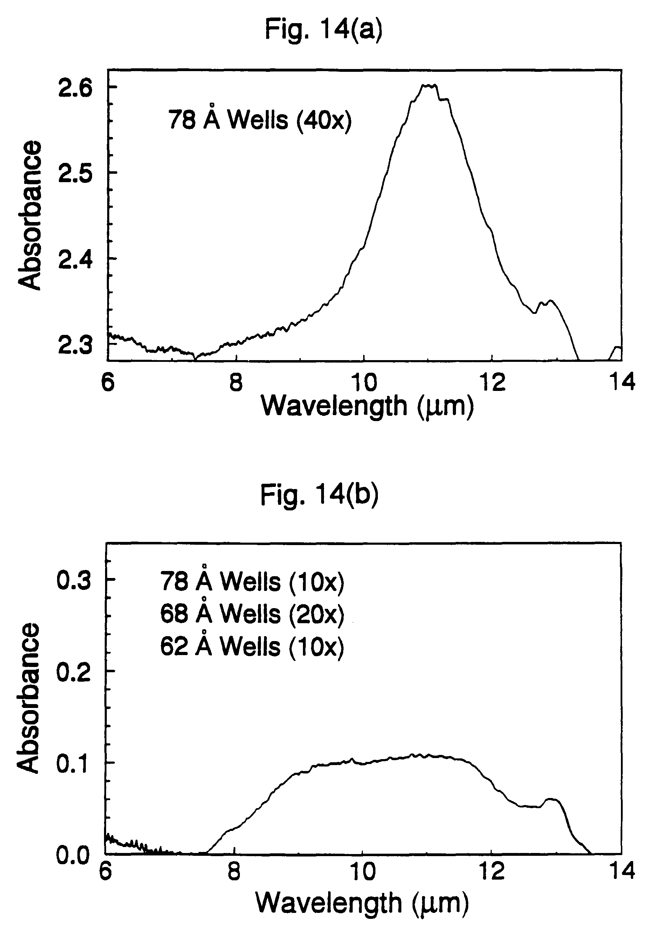

Figs. 14(a)-14(b) show experimental verification of the calculated spectra illustrated in Fig. 13. Fig. 14(a) shows a measured absorption spectrum of an MBT detector having forty 78-Å-wide quantum well layers and having the wells' excited states positioned near the bottom of the miniband. Fig. 14(b) shows a measured absorption spectrum of a broad-band MBT detector having ten 78-Å-wide quantum wells, twenty 68-Å-wide quantum wells, and ten 62-Å-wide quantum wells. The detectors that yielded the measured spectra shown in Figs. 14(a)-14(b) had superlattice barrier layers formed of thin alternating layers of GaAs (20 Å) and $Al_{0.3}Ga_{0.7}As$ (40 Å). The figures demonstrate that, in accordance with Applicant's invention, an exact approach to Schroedinger's equation can be used to create a pattern of quantum well excited state energies positioned in a superlattice barrier miniband and obtain a broad-band, uniform-response QWIP.

It can be noted that Figs. 14(a)-14(b) also experimentally verify the calculated performance of an MBT detector in which the excited states are positioned near the top of the miniband. In such a detector, carriers in the ground state can be more readily thermally excited into the miniband states, and a greater dark current typically would result. The same is generally true for MBT detectors having wide minibands, which is in contrast to a narrow-miniband detector like the one described in the Coon et al. paper that would have advantageously low dark current (but also low photocurrent). Nevertheless, increasing the miniband width in an MBT detector in which the well's excited state is positioned near the bottom of the miniband does not result in a significant increase in dark current at an operating temperature of 77 K because the carrier density decreases exponentially as the energy increases. Thus, the bottom of the miniband is a major factor in determining the dark current.

The thermal-excitation component of the dark current can be reduced by reducing the detector's operating temperature below 77 K, but this is usually disadvantageous except in special environments such as space-based systems. Moreover, reducing the thermal-excitation component of the dark current by lowering the operating temperature makes the component of the dark current due to tunneling through the superlattice barrier layers relatively more important. As described above, the tunneling component can be reduced by making the superlattice barrier layers thicker, but this increases the chances that the carriers may lose too much energy and recombine before they are transported out of the detector.

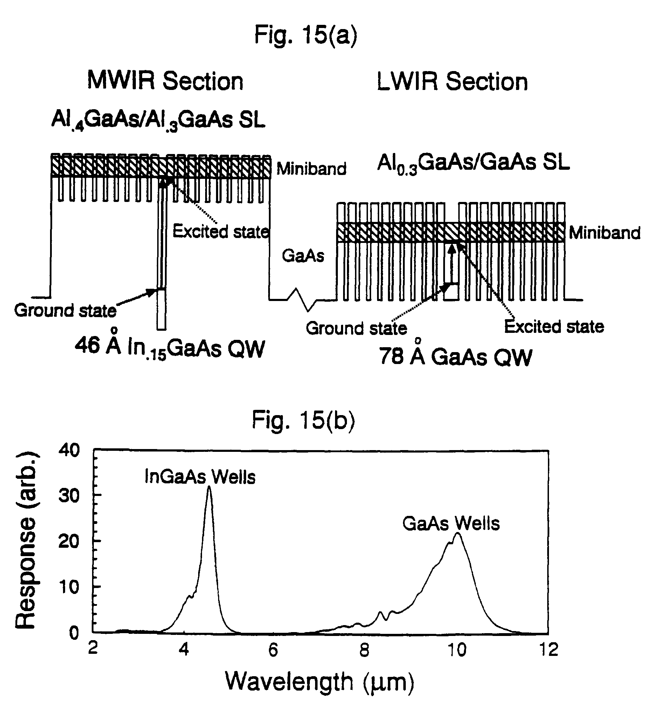

A two-color MBT detector may include two MBT detector sections in which the compositions and layer thicknesses of one section are selected such that the section's peak-response wavelength falls in a first wavelength band and the composition and layer thicknesses of the other section are selected such that the peak-response wavelength falls in a second wavelength band. Fig. 15(a) illustrates the energy states and layer compositions and thicknesses for such a two-color MBT detector.

When the first MBT detector section has 46-Å-wide quantum well layers of $In_{0.15}Ga_{0.85}As$ interleaved with superlattice barrier layers formed of thin alternating layers of $Al_{0.4}Ga_{0.6}As$ and $Al_{0.3}Ga_{0.7}As$, the first wavelength band is in the MWIR atmospheric transmission window. When the second MBT detector section has 78-Å-wide quantum well layers of GaAs interleaved with superlattice barrier layers formed of thin alternating layers of $Al_{0.3}Ga_{0.7}As$ and GaAs, the second wavelength band is in the LWIR atmospheric transmission window. The LWIR detector section could be disposed either atop or below the MWIR detector section on the substrate. The sections, which would have the structures generally illustrated in Fig. 3, would be separated by a suitably doped GaAs contact layer, thereby providing for independent section biasing and readout.

Fig. 15(b) shows a measured photocurrent response spectrum of a two-color MBT detector comprising forty periods of the MWIR section having quantum well layers doped to a concentration of $1 \times 10^{18}$ cm$^{-3}$ and forty periods of the LWIR section having quantum well layers doped to a concentration $4 \times 10^{17}$ cm$^{-3}$ described above in connection with Fig. 15(a). The figure indicates that an army of MBT detectors can be fabricated in which photoresponse in two distinct wavelength bands is obtained simultaneously from each pixel.

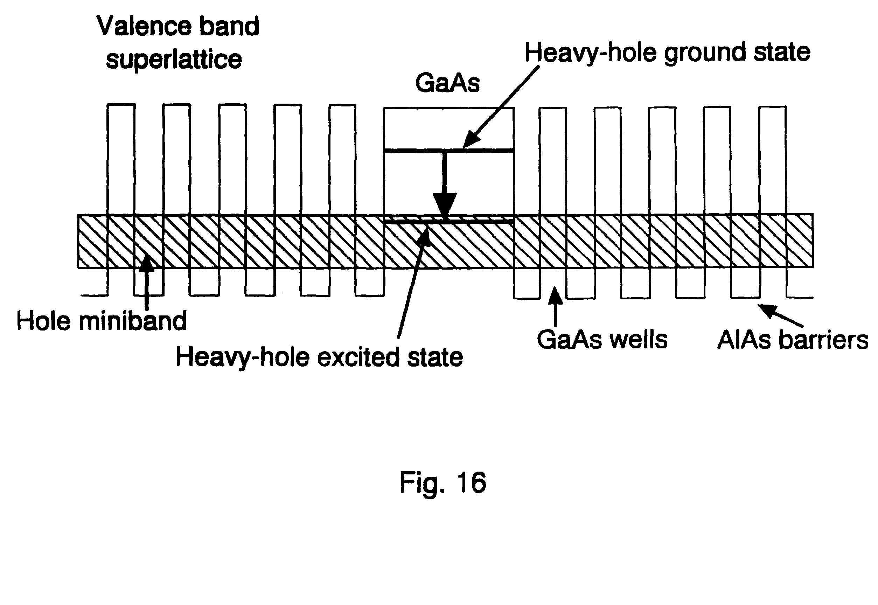

Fig. 16 illustrates the energy states of another MBT detector (which may be used in the Applicant's invention) in which the quantum well layers would be doped with p-type impurities such as beryllium. In addition, the layer thicknesses and compositions would be chosen such that the excited state of heavy holes in the wells' valence band is in resonance with a heavy-hole miniband formed in the valence band of the superlattice barrier layers. Such a p-type MBT detector having a peak-response wavelength of about 10 μm could have 41-Å-wide GaAs quantum wells doped to a concentration of about $3 \times 10^{18}$ cm$^{-3}$ and superlattice barrier layers comprising thin alternating layers of GaAs (14-Å-wide wells and AlAs (14-Å-wide barriers). For such compositions and thicknesses, the superlattice barrier layers would have a heavy-hole miniband that is approximately 32 MeV wide.

Such p-type MBT detectors would have significant potential advantages, one of which would be operation at higher temperature. For a given doping level, the thermionic emission of heavy holes would be much lower than the thermionic emission of electrons because the fermi level for heavy holes does not increase with increasing temperature nearly as rapidly as it does for electrons. On the other hand, the minibands of p-type MBT detectors tend to be narrower than those of n-type MBT detectors because of the heavy holes' larger effective mass, although a heavy hole miniband that is 50 meV wide is described in the above-cited Leavitt et al. paper, which is incorporated here by reference. As described above, a narrower miniband would require lower applied bias to avoid localization. Moreover, it will be appreciated that it is not possible for a conventional QWIP to have only one bound hole state, an excited hole state near the top of the barrier, and a transition energy that yields response in the LWIR band.

Applicant's invention provides an electromagnetic detector having optical and carrier-transport properties that can be varied over a wide range by selecting among a variety of quantum well widths, numbers and compositions and superlattice barrier layer thicknesses and compositions. The optical bandwidth of the detector can be tailored by positioning the wells' excited state energies in a predetermined pattern within the superlattice barriers' miniband, and improved optical performance for imaging detector arrays results. An MBT detector having response in two or more wavelength bands can be formed. By avoiding the conventional QWIP's restriction to only one bound state, MBT detectors in accordance with Applicant's invention can use p-type dopants and obtain higher-temperature, LWIR operation.

It will be appreciated that modifications may be made without departing from the scope of the invention defined in the appended claims.

**Claims**

1. A broad-band semiconductor miniband-transport quantum well detector, comprising:

> a substrate;
> means, disposed on the substrate, for absorbing incident photons, the absorbing means comprising a multilayer structure including

>> a first plurality of first quantum well layers, each first layer having a bound ground energy state and a bound excited energy state,
>> a second plurality of second quantum well layers, each second layer having a bound ground energy state and a bound excited energy state,
>> a third plurality of third quantum well layers, each third layer having a bound ground energy state and a bound excited energy state, and
>> a plurality of superlattice barrier layers interleaved between the first, second, and third quantum well layers, each superlattice barrier layer having a miniband of energy states in resonance with the excited energy states of its adjacent quantum well layers; and

> first and second contact layers disposed on top and bottom surfaces, respectively, of the multilayer structure; wherein the minibands and excited energy states provide an electrically continuous channel across the layers for carriers excited from the ground energy states to the excited energy states and minibands by absorption of photons when different electric potentials are applied to the contact layers, the excited energy states of the first quantum well layers are positioned near the bottom of the minibands, the excited energy states of the second quantum well layers are positioned near the middle of the minibands, and the excited energy states of the third quantum well layers are positioned near the top of the minibands.

2. The detector of claim 1, wherein the second plurality is greater than at least one of the first and third pluralities.

3. The detector of claim 1 or 2, wherein each first quantum well layer comprises doped gallium arsenide having a first predetermined thickness, each second quantum well layer comprises doped gallium arsenide having a second predetermined thickness that is less than the first predetermined thickness, and each third quantum well layer comprises doped gallium arsenide having a third predetermined thickness that is less than the first and second predetermined thicknesses.

**Patentansprüche**

1. Breitbandiger Halbleiter-Quantenwell-Detektor mit Minibandtransport, mit:

einem Substrat,

auf dem Substrat angeordnete Einrichtungen zum Absorbieren einfallender Photonen, wobei die Absorptionseinrichtung einen mehrschichtigen Aufbau aufweist, einschließlich

einer ersten Mehrzahl von ersten Quantenwell-Schichten, wobei jede erste Schicht einen gebundenen Energiegrundzustand und einen gebundenen angeregten Energiezustand hat,
einer zweiten Mehrzahl von zweiten Quantenwell-Schichten, wobei jede zweite Schicht einen gebundenen Energiegrundzustand und einen gebundenen, angeregten Energiezustand hat,
eine dritte Mehrzahl von dritten Quantenwell-Schichten, wobei jede dritte Schicht einen gebundenen Energiegrundzustand und einen gebundenen angeregten Energiezustand hat und
eine Mehrzahl von Übergitterbarrierenschichten, die jeweils zwischen den ersten, zweiten und dritten Quantenwell-Schichten angeordnet sind, wobei jede Übergitterbarrierenschicht ein Miniband von Energiezuständen hat, die sich in Resonanz mit den angeregten Energiezuständen der jeweiligen benachbarten Quantenwellschichten befinden, und

ersten und zweiten Kontaktschichten, die an den oberen bzw. unteren Flächen des mehrschichtigen Aufbaus angeordnet sind,
wobei die Minibänder und die angeregten Energiezustände einen elektrisch durchgehenden Kanal über die Schichten hinweg bereitstellen für Ladungsträger, die aus den Energiegrundzuständen in die angeregten Energiezustände und die Minibänder angeregt worden sind durch Absorption von Photonen, wenn unterschiedliche elektrische Potentiale an den Kontaktschichten angelegt werden, wobei die angeregten Energiezustände der ersten Quantenwell-Schichten in der Nähe des unteren Teils der Minibänder angeordnet sind, die angeregten Energiezustände der zweiten Quantenwell-Schichten in der Nähe des mittleren Bereichs der Minibänder angeordnet sind, und die angeregten Energiezustände der dritten angeregten Quantenwell-Schichten in der Nähe des oberen Randes der Minibänder angeordnet sind.

2. Detektor nach Anspruch, wobei die zweite Mehrzahl größer ist als zumindest eine der ersten und dritten Mehrzahlen.

3. Detektor nach Anspruch 1 oder 2, wobei jede erste Quantenwell-Schicht dotiertes Galliumarsenid einer ersten vorbestimmten Dicke aufweist, wobei jede zweite Quantenwell-Schicht dotiertes Galliumarsenid aufweist, welches eine zweite vorbestimmte Dicke hat, die geringer ist als die erste vorbestimmte Dicke, und wobei jede dritte Quantenwell-Schicht dotiertes Galliumarsenid aufweist, welches eine dritte vorbestimmte Dicke hat, die geringer ist als die ersten und die zweiten vorbestimmten Dicken.

**Revendications**

1. Détecteur à puits quantiques à transport à minibandes à semiconducteurs à large bande, comprenant :

un substrat ;
des moyens, disposés sur le substrat, pour absorber les photons incidents, les moyens d'absorption comprenant une structure multicouche comprenant :

une première pluralité de premières couches à puits quantiques, chaque première couche ayant un état d'énergie de masse lié et un état d'énergie excitée lié,
une deuxième pluralité de deuxièmes couches à puits quantiques, chaque deuxième couche ayant un état d'énergie de masse lié et un état d'énergie excitée lié,
une troisième pluralité de troisièmes couches à puits quantiques, chaque troisième couche ayant un état d'énergie de masse lié et un état d'énergie excitée lié, et
une pluralité de couches d'arrêt à super-réseau entremêlées entre les première, deuxième et troisième couches à puits quantiques, chaque couche d'arrêt à superréseau ayant une minibande d'états d'énergie en résonance avec les états d'énergie excitée de ses couches à puits quantiques adjacentes ; et

des première et deuxième couches de contact disposées sur les surfaces supérieure et inférieure, respectivement, de la structure à couches multiples ;
dans lequel les minibandes et les états d'énergie excitée constituent un canal électriquement continu dans les couches pour les porteurs excités des états d'énergie de masse aux états d'énergie excitée et minibandes par absorption de photons lorsque des potentiels électriques différents sont appliqués aux couches de contact, les états d'énergie excitée des premières couches à puits quantiques sont positionnés au voisinage du fond des minibandes, les états d'énergie excitée des deuxièmes couches à puits quantiques sont positionnés au voisinage du milieu des minibandes, et les états d'énergie excitée des troisièmes couches à puits quantiques sont positionnés au voisinage du haut des minibandes.

2. Détecteur selon la revendication 1, dans lequel la deuxième pluralité est supérieure à au moins l'une des première et troisième pluralités.

3. Détecteur selon la revendication 1 ou 2, dans lequel chaque première couche à puits quantiques comprend de l'arséniure de gallium dopé ayant une première épaisseur prédéterminée, chaque deuxième couche à puits quantiques comprend de l'arséniure de gallium dopé ayant une deuxième épaisseur prédéterminée qui est inférieure à la première épaisseur prédéterminée, et chaque troisième couche à puits quantiques comprend de l'arséniure de gallium dopé ayant une troisième épaisseur prédéterminée qui est inférieure aux première et deuxième épaisseurs prédéterminées.

## FIG. 1(a)
PRIOR ART

EXCITED STATE

BARRIER

DOPING LEVEL

QW

GROUND STATE

QW

QW

## FIG. 1(b)
PRIOR ART

PHOTOCURRENT

QW

QW

PHOTON
ABSORPTION

QW

DARK CURRENT

# FIG. 2(a)
## PRIOR ART

VIRTUAL EXCITED STATE

CONTINUUM

BARRIER

DOPING LEVEL

QW

GROUND STATE

QW

QW

# FIG. 2(b)
## PRIOR ART

PHOTOCURRENT

QW

INFRARED PHOTON
ABSORPTION

QW

QW

DARK CURRENT

EP 0 648 377 B1

FIG. 3

LWIR
RADIATION

FIG. 4

EXCITED STATE 110 120 MINIBAND 100

SL20₁   QW10₂   SL20₂   QW10₃   SL20₃
GROUND STATE

FIG. 5(a)

PHOTOCURRENT

SL20₁   INFRARED PHOTON ABSORPTION   QW10₂   SL20₂   QW10₃   DARK CURRENT   SL20₃

FIG. 5(b)

EP 0 648 377 B1

FIG. 6

FIG. 7

## Fig 8(a)

Excited state

Miniband states

Ground state

## Fig. 8(b)

## Fig. 9(a)

Excited state

Miniband states

Ground state

## Fig. 9(b)

## Fig. 10(a)

Excited state

Miniband states

Ground state

## Fig. 10(b)

Absorption (arb.)

Wavelength (μm)

## Fig. 11(a)

## Fig. 11(b)

## Fig. 12(a)

**Well 1**　　　**Well 2**　　　**Well 3**

## Fig. 12(b)

Fig. 13

## Fig. 14(a)

78 Å Wells (40x)

Absorbance vs Wavelength (μm)

## Fig. 14(b)

78 Å Wells (10x)
68 Å Wells (20x)
62 Å Wells (10x)

Absorbance vs Wavelength (μm)

## Fig. 15(a)

MWIR Section  Al$_{.4}$GaAs/Al$_{.3}$GaAs SL

LWIR Section  Al$_{0.3}$GaAs/GaAs SL

Miniband
Excited state
Ground state
46 Å In$_{.15}$GaAs QW

GaAs

Miniband
Ground state  Excited state
78 Å GaAs QW

## Fig. 15(b)

Fig. 16